Europäisches Patentamt

(19) European Patent Office

Office européen des brevets

(11) Publication number: **0 196 475**
**B1**

(12) **EUROPEAN PATENT SPECIFICATION**

(45) Date of publication of the patent specification:
31.10.90

(21) Application number: **86102791.0**

(22) Date of filing: **04.03.86**

(51) Int. Cl.⁵: **G01R 31/308, H01L 23/544**

(54) Noncontact testing of integrated circuits.

(30) Priority: **29.03.85 US 717409**

(43) Date of publication of application:
**08.10.86 Bulletin 86/41**

(45) Publication of the grant of the patent:
**31.10.90 Bulletin 90/44**

(84) Designated Contracting States:
**DE FR GB IT**

(56) References cited:
**EP-A- 0 005 762**

**IBM TECHNICAL DISCLOSURE BULLETIN, vol. 15, no. 6, November 1972, pages 2032-2033, New York, US; R.F. BUSH et al; "Photoconductor contacting for module testing"**
**SOLID-STATE COMMUNICATIONS, vol. 20, no. 3, 1976, pages 179-182, Pergamon Press, Oxford, GB; Z.A. WEINBERG et al.: "Photon assisted tunneling from aluminum into silicon dioxide"**

(73) Proprietor: **International Business Machines Corporation, Old Orchard Road, Armonk, N.Y. 10504(US)**

(72) Inventor: **Beha, Johannes Georg, Santisstrasse 75, CH-8820 Wadenswil(CH)**
Inventor: **Dreyfus, Russell Earren, 70 Barker Street, Mt. Kisco New York 10549(US)**
Inventor: **Hartstein, Allan Mark, 5 Deborah Lane, Chappaqua New York 10514(US)**
Inventor: **Rubloff, Gary Wayne, 16 Nightingale Road, Katonah New York 10536(US)**

(74) Representative: **Atchley, Martin John Waldegrave, IBM United Kingdom Limited Intellectual Property Department Hursley Park, Winchester Hampshire SO21 2JN(GB)**

**Description**

This invention relates to noncontact testing of integrated circuits.

Z. A. Weinberg and A. Hartstein, "Photon Assisted Tunneling from Aluminium into Silicon Dioxide," Solid State Communications 20, 179 (1976) describes the theory of photon assisted electron tunneling and its use in an experimental demonstration.

EP-A-0 180 780 (Application No. 85112610,2), published on 14.05.1986, shows a tester which allows testing in vacuum of the dynamic operation and performance of high-speed very large scale integration (VLSI) circuits, including on-chip contactless measurement of AC switching waveforms (picosecond time scales) as well as logic state evaluation (nanosecond time scales) using high energy photons (about 5-6 eV).

Electron beam testing methods are also known. These testing methods also require surface availability of metal conductor points and are therefore inadequate for testing of passivated circuits. Furthermore, the electron beam causes damage to passivating layer materials such as oxides and must therefore be carefully directed away from such areas even in current electron-beam testing of metal points available at the surface.

The invention permits room-environment noncontact testing even though the integrated circuit be passivated by an insulation layer, does not require high energy beams, and does not require contacts open to the surface.

The object of the invention is to provide sensitive room-environment real-time laser testing of integrated circuits with test access pads buried underneath a passivation layer, by the use of a transparent conductive metallic overlayer on the chip-to-test.

Another object of the invention is to extend laser testing of VLSI and VHSIC circuits to carry out room-environment real-time testing of AC switching waveforms and logic states with oxide, insulator, or passivation layers present on top of the metal test points, thus bringing the method closer to addressing the condition of the chip after manufacturing and making possible the testing in air rather than in a vacuum.

The invention relates to a method of testing an integrated circuit chip-to-test which is characterised in that each integrated circuit to be placed under test has at least one conductive test site, the test sites are covered by a passivation layer, the passivation layer being of a material which is photon transmissive and susceptible to photon assisted tunneling, and a thin conductive overlayer is provided over the passivation layer, the overlayer being transparent to photons.

Integrated circuit test exercise means are applied to the chip-to-test to cause electronic activity in the chip-to-test appropriate to the desired test, so as to provide at a given test site a voltage potential related to operation.

Pulsed laser means are operated to access a selected test site on the chip-to-test so as to excite photoemission of photo-excited electrons from the test site at values related to the instantaneous voltage potential at the accessed test site whereby the accessed test site provides via tunneling of the photo-excited electrons through the passivation layer to the conductive overlayer differing values of electron currents as a function of operation voltage differences.

Current measurement means is connected to the overlayer to take readings of tunneling electron currents which in turn are a composite function of the laser light excitation of the test sites and the instantaneous voltage at such test sites, whereby the test site accessed by the pulsed laser means provides differing readings for proper operation and for faulty operations, and the integrating circuit may be tested without destructive contact probing.

The invention also relates to an integrated circuit chip-to-test having a plurality of operational integrated circuits arrayed under a passivation layer which is characterised in that the passivation layer is of a material which is photon transmissive and susceptible for electron tunneling of photo-excited electrons, that a plurality of conductive test pads is provided associated with circuits to be tested at locations accessible by photons through the passivation layer, and a photon-transparent electrically conductive overlayer is provided over the passivation layer to constitute test output connecting means, whereby such chip-to-test may be mounted for exercise in a test operational mode, test sites may be laser accessed during exercise, and electron tunneling values related to operational parameters may be taken from the transparent conductive layer.

In this specification, "chip-to-test" means a chip having an integrated circuit and intended to be tested.

An advantage of the invention is that the combination of thin insulation layer and thin collector layer provides a transfer path for relatively low energy photons to result in photoemission of electrons and thus require relatively low energy laser selection beams available from conventional lasers.

The manufacturing advantage of truly nondestructive testing in air, with passivation layers present, which allows testing in the same tool used to carry out personalization, significantly extends the economic advantages of in-process testing by providing freer choice of test time and easier test setup.

The scope of the invention is defined by the appended claims; and how it can be carried into effect is more particularly described hereinafter with reference to the accompanying drawings, in which:-

FIG. 1 is a schematic diagram of a chip-to-test according to the invention and the system used in a testing method according to the invention;

FIG. 2 is an energy level diagram illustrating tunneling from the metal test point on the chip through the passivation layer to the conductive overlayer; and

FIG. 3 is a simplified diagram of a chip-to-test according to the invention with features enhancing testability.

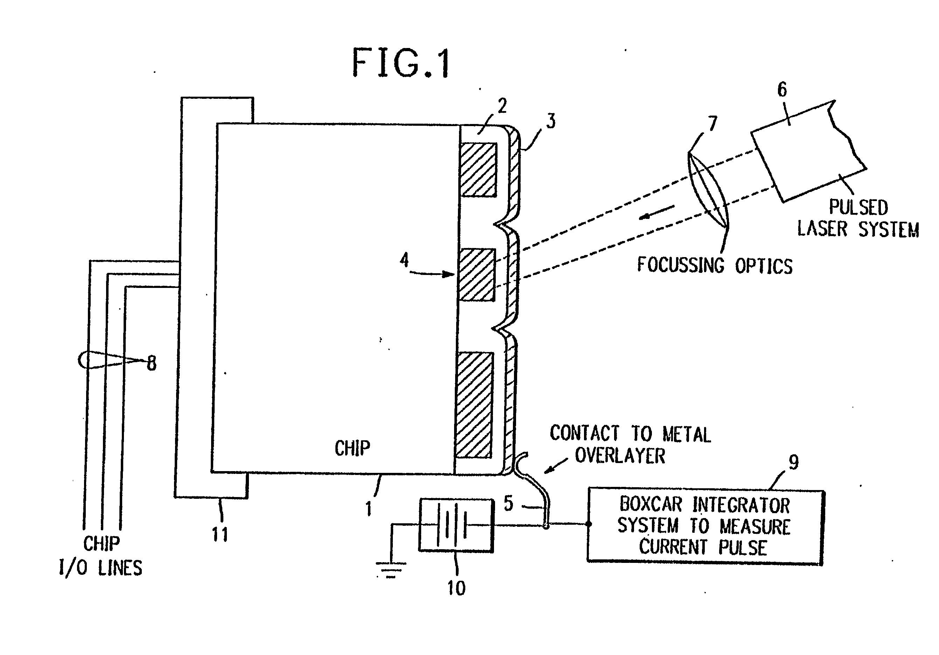

A chip-to-test 1 (Fig. 1) is mechanically and electrically mounted in a holder 11. The chip-to-test 1 has an insulating layer 2 as passivation, and a conductive metal overlayer 3 which serves as collector for detector logic 9 to which it is connected by output contact 5. The detector logic 9 is a boxcar integrator system to measure the current pulse. The conductive overlayer 3 may be biased by electrical bias generator 10 to control the threshold for photon assisted tunneling. The chip-to-test 1 has a number of metal test points 4 onto one of which is focussed a laser beam from a laser 6 forming part of a pulsed laser system, by focussing optics 7. Chip input/output lines 8 are connected to holder 11.

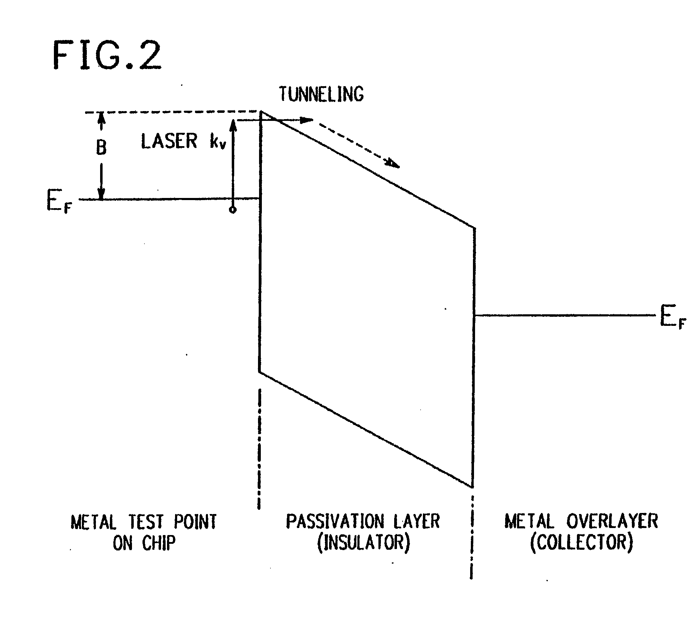

An integrated circuit is accessed for testing by focussing a pulsed laser beam onto an included metal test point 4 buried underneath the thin film insulating layer 2 and metallic overlayer 3, causing photoemission of electrons out of the metal test pad, through the insulator to the metallic overlayer as collector. The metal overlayer (collector) is effectively transparent to the laser light because it is thin (a few tens of nanometres or less) or optically transparent. The laser beam passes through the metallic overlayer and the passivation layer readily; the result is photoemission caused by relatively low energy laser photons (about 2.5-3.0eV). FIG. 2 is an energy level diagram showing laser-induced excitation of electrons in the metal test point followed by tunneling through the insulation (passivation) layer 2 (FIG. 1) to the conducting layer 3 (FIG. 1) which serves as collector. Even lower laser photon energies are employed than the barrier energy B (FIG. 2) because the laser photon energy needed for electron emission from the metal test point into the insulator conduction band should be slightly less than the normal threshold. In this way, with an electric field applied across the insulator, tunneling occurs to the layer 3 from the metal test point interface with the insulator.

A pulsed laser beam (about 5 picoseconds pulse width or less) is focussed onto a metal test point (about 1 micrometre diameter or less), but in this case the test point is buried underneath a thin film insulating layer (e.g., silicon dioxide) of order 0.1 - 1.0 micrometres thick. The presence of the insulator or passivation layer causes two fundamental changes in the situation.

First, the threshold energy for photoelectron emission from the metal test pad into the insulator is notably lowered by the insulating layer. Weinberg and Hartstein show that the threshold for injecting electrons from the metal into the insulator conduction band is only 3.15 eV for the aluminium/silicon dioxide interface, compared to about 4.2 eV from air-exposed aluminium into vacuum. This threshold-lowering makes it possible to use laser photons with lower energy, i.e., in the range around 2.5-3.0eV. Because most insulators used in devices as oxides or passivation layers are transparent in this range, the laser light passes through the passivation layer readily. Such lower energy laser photons are much easier to generate using conventional laser sources than are higher energy photons. Even lower energies are employed because the laser photon energy should be slightly less than the normal threshold needed for direct electron emission from the metal test point over the barrier (Ref. B in FIG. 2) and into the insulator conduction band. The tunneling through the barrier is enabled by the electric field present across the insulator due to the voltage bias applied to the metallic overlayer as referenced to the voltage of the metal test point.

Second, a different method must be used to discriminate the voltage of the metal test point. This method is shown schematically in Fig. 1. After fabrication of the chip 1 is complete and the passivation layer 2 has been added, a thin metallic overlayer 3 (collector) consisting of a thin conductive metal or a conducting transparent layer like tin oxide is deposited on top of the passivation layer 2. The conducting overlayer 3 is sufficiently thin or otherwise transparent that the incident laser beam can still penetrate to the metal test pad 4. For an absorbing metal collector, the thickness should be of order of 10 nm. By contacting the collector electrically, with contact 5, conducting overlayer 3 can be biased and used to measure the current it collects. The testing procedure then consists of measuring the current pulse collected as a result of the picosecond laser pulse applied to a specific metal test point on the chip at a specific time. The conducting overlayer 3, thin metal on top of the passivation layer 2, can then be removed if needed.

To achieve voltage sensitivity, the small changes in voltage of the metal test point must result in significant changes in the amount of current measured at the collector. Once electrons have been excited into the insulator conduction band, they can travel substantial distances (well over 100 nm even for a poor quality oxide) in the presence of an accelerating field. The voltage sensitivity needed is obtained by photon-assisted tunneling as depicted in Fig. 2. The laser photon energy is chosen to be somewhat below the threshold for direct photoemission from the metal test pad into the insulator conduction band (B in FIG. 2). The laser photon excites electrons to an energy just below that of the top of the interface barrier (at the metal test point/insulator interface), and these excited electrons can then tunnel through the barrier. Because the tunneling probability depends exponentially on the field in the insulator and the collector bias is fixed, the tunneling current measured at the collector is very sensitive to the voltage of the metal test pad (emitter). The largest signals are obtained by choosing the laser photon energy very close to the energy threshold B, while highest voltage sensitivity is achieved by reducing the tunneling current somewhat and operating somewhat further below threshold (e.g., by 0.5eV). For the aluminium/silicon dioxide interface, conventional argon and krypton lasers, which are readily focussed to near diffraction limits (one micrometre spot size or less) and mode-locked to achieve picosecond pulse widths, provide the right range of photon energies for this method.

The laser testing method disclosed here is directed at real-time contactless testing of internal nodes on the chip when passivation layers are already present. Passivation or insulating layers are required. The testing need not be carried out in vacuum, which is a very significant advantage. The chip-to-test may be a full wafer, an area on a wafer, a full chip, an area on a chip, or other related item, and may be called simply a "chip".

Three specific applications are as follows:

First, testing of a fully manufactured product can be carried out after the chip has been completed, in which case the blanket metal overlayer is deposited, the testing done, and if desired the metal overlayer removed (by ion sputtering or chemical etching, for example).

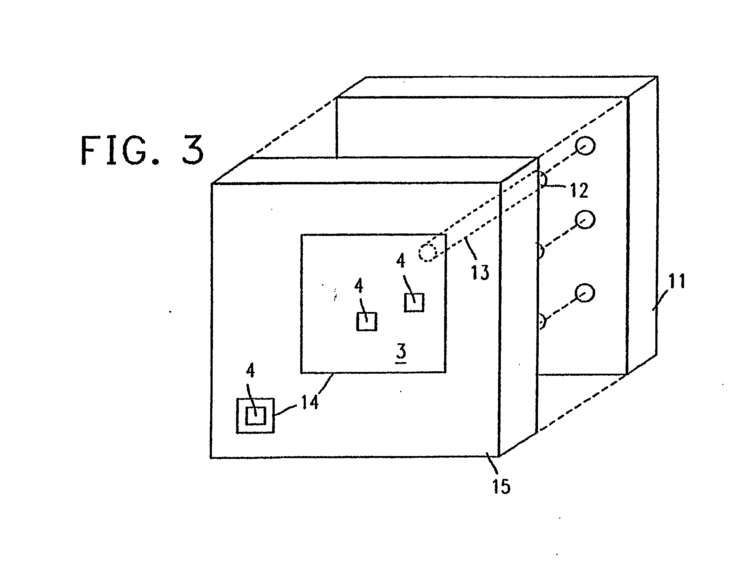

Second, the product chip may be manufactured with the blanket metal testing overlayer on top of the passivation layer and one I/O pin 12 (FIG. 3) in the chip package may be reserved as a contact, connected by via connection 13 to the conductive overlayer. The testing of representative test sites 4 can be carried out on the packaged chip, in an in-line socket mount with optical windows 14 included in the package to permit entry of the laser light. Light other than at windows 14 may be blocked by opaque passivation or intervening layers 15, shown diagrammatically in FIG. 3.

Third, at some critical stages of the manufacturing process or during advanced development, oxide or passivation layers and metal testing overlayers may be added to carry out real-time testing; if the chip qualifies, these layers may then be removed and further processing done.

In cases where in-air testing is desirable but there is no permanent passivation layer in place, a thin (few tens of nanometres thick) temporary passivation layer, of insulating material such as a silicon oxide or plastic such as polyimide, may be temporarily deposited prior to deposition of the thin conductive overlayer.

There has been described a photon energised tunneling room-environment testing procedure by which conductive test sites of a passivated integrated circuit wafer, covered with a thin layer of insulation and a transparent conductive layer, are accessed through the transparent conductive layer and the insulation layer by a pulsed laser to provide voltage-modulated photoexcited electrons which tunnel through the insulation layer to the conductive layer and are detected to provide a nondestructive test of integrated circuits during manufacture or subsequently.

## Claims

1. A method of testing an integrated circuit chip-to-test, characterised in that each integrated circuit to be placed under test has at least one conductive test site (4), the test sites are covered by a passivation layer (2), the passivation layer being of a material which is photon transmissive and susceptible to photon assisted tunneling, a thin conductive overlayer (3) is provided over the passivation layer (2), the overlayer being transparent to photons, integrated circuit test exercise means are applied to the chip-to-test to cause electronic activity in the chip-to-test appropriate to the desired test, so as to provide at a given test site a voltage potential related to operation,

pulsed laser means (6) are operated to access a selected test site on the chip-to-test so as to excite photoemission of photo-excited electrons from the test site at values related to the instantaneous voltage potential at the accessed test site whereby the accessed test site provides, via tunneling of the photo-excited electrons through the passivation layer (2) to the conductive overlayer (3), differing values of electron currents as a function of operation voltage differences, and

current measurement means (9) is connected to the overlayer (3) to take readings of tunneling electron currents which in turn are a composite function of the laser light excitation of the test sites and the instantaneous voltage at such test sites, whereby the test site accessed by the pulsed laser means provides differing readings for proper operation and for faulty operations, and the integrating circuit may be tested without destructive contact probing.

2. A method according to claim 1, characterised in that bias means (10) is connected to the overlayer (3) of the integrated circuit under test to control the threshold for tunneling of the photo-excited electrons whereby the test pad accessed by the pulsed laser means provides significantly differing readings for proper operation and for faulty operations.

3. A method according to claim 1 or 2, characterised in that the conductive overlayer (3) is removed after testing has been completed.

4. A method according to claim 1, 2 or 3, characterised in that the chip-to-test (1) is placed in a mounting (11) having electrical connections (8) complementary to input/output connections of the chip-to-test, and supporting the chip-to-test for accessibility by laser photons to the test sites (4).

5. An integrated circuit chip-to-test having a plurality of operational integrated circuits which are arrayed under a passivation layer (2), characterised in that the passivation layer (2) is of a material which is photon transmissive and susceptible for electron tunneling of photo-excited electrons, that a plurality of conductive test pads (4), is provided associated with circuits to be tested at locations accessible by photons through the passivation layer; and a photon-transparent electrically conductive overlayer (3) is provided over the passivation layer (2) to constitute test output connecting means, whereby such chip-to-test may be mounted for exercise in a test operational mode, test sites may be laser accessed during exercise, and electron tunneling values related to operational parameters may be taken from the transparent conductive layer.

6. A chip-to-test according to claim 5, characterised by at least one input-output contact (12) designated for test connection and connections means (13) connecting the test connection contact (12) to the transparent conductive overlayer (3) (Fig. 3).

7. A chip-to-test according to claim 5 or 6, characterised by a photon-opaque passivation layer (15), in which photon-transparent window openings (14) provide access for laser light to test sites (4) (Fig. 3).

## Patentansprüche

1. Verfahren zum Testen eines zu testenden Chips eines integrierten Schaltkreises, dadurch gekennzeichnet, daß jeder zu testende integrierte Schaltkreis zumindest eine leitende Teststelle (4) aufweist, daß die Teststellen durch eine Passivierungsschicht (2) abgedeckt sind, wobei die Passivierungsschicht aus einem Material besteht, welches photonentransmissiv ist und photonenunterstützten Tunneldurchbruch zuläßt, wobei eine dünne leitende Oberschicht (3) über der Passivierungsschicht (2) angebracht ist, wobei die Oberschicht photonentransparent ist,
Test-Übungsmittel für integrierte Schaltkreise werden angewendet für das zu testende Chip, um elektronische Aktivität in dem zu testenden Chip hervorzurufen, die dem gewünschten Test angemessen sind, wie z.B. die Anleitung eines auf die Funktion bezogenen Spannungspotentials an eine gegebene Teststelle,
pulsierte Lasermittel (6) werden betätigt, um auf eine ausgewählte Teststelle auf dem zu testenden Chip zuzugreifen, um Photoemission von unter Photoanregung stehenden Elektronen aus der Teststelle anzuregen, bei Werten, die auf das momentane Spannungspotential an der Teststelle, auf die zugegriffen wurde, bezogen sind, wobei die Teststelle, auf die zugegriffen wurde, durch den Tunneldurchbruch der unter Photoanregung stehenden Elektronen durch die Passivierungsschicht (2) hindurch zu der leitenden Oberschicht (3) verschiedene Werte von Elektronenströmen in Abhängigkeit von Funktionsspannungsunterschieden liefert, und
Strommeßmittel (9) sind an die Oberschicht (3) angeschlossen, um Tunneldurchbruch-Elektronenströme abzulesen, welche dann wieder eine zusammengesetzte Funktion der Laserlichtanregung der Teststellen und der momentanen Spannung an derartigen Teststellen sind, wobei die Teststellen, auf welche von den pulsierten Lasermitteln zugegriffen wurde, unterschiedliche Anzeigen für richtige Funktion und für fehlerhafte Funktionen liefern, und der integrierte Schaltkreis kann ohne destruktive Kontaktsondierung getestet werden.

2. Verfahren nach Anspruch 1, dadurch gekennzeichnet, daß Vorspannungsmittel (10) an die Oberschicht (3) des im Test befindlichen integrierten Schaltkreises abgeschlossen sind, um den Schwellenwert für den Tunneldurchbruch der unter Photoanregung stehenden Elektronen zu kontrollieren, wobei die Testanschlußfläche, auf die von den pulsierten Lasermitteln zugegriffen wurde, signifikante unterschiedliche Anzeigen für richtige Funktion und für fehlerhafte Funktionen liefert.

3. Verfahren nach Anspruch 1 oder 2, dadurch gekennzeichnet, daß die leitende Oberschicht (3) nach der Test-Beendigung entfernt wird.

4. Verfahren nach Anspruch 1, 2 oder 3, dadurch gekennzeichnet, daß das zu testende Chip (1) in einem Aufbau (11) angebracht wird, welcher zusätzlich zu den Ein-Ausgangsanschlüssen des zu testenden Chips elektrische Anschlüsse (8) aufweist und das zu testende Chip lagert, um die Zugänglichkeit zu den Teststellen (4) durch Laserphotonen zu ermöglichen.

5. Zu testendes Chip eines integrierten Schaltkreises mit einer Vielzahl von integrierten Funktionsschaltkreisen, welche unter einer Passivierungsschicht (2) angeordnet sind, dadurch gekennzeichnet, daß die Passivierungsschicht (2) aus einem Material besteht, welches photonentransmissiv ist und Elektronen-Tunneldurchbruch von unter Photoanregung stehenden Elektronen zuläßt, daß die Vielzahl von leitenden Testanschlußflächen (4) bereitgestellt ist, welche zu testenden Schaltkreisen zugeordnet sind, an Stellen, die den Photonen durch die Passivierungsschicht hindurch zugänglich sind; und eine photonentransparente elektrisch leitende Oberschicht (3) über der Passivierungsschicht (2) angeordnet ist, um Testausgangsanschlußmittel zu bilden, wobei ein derartiges zu testendes Chip zur Übung in einer Test-Betriebsart montiert werden kann, auf Teststellen während der Übung vom Laser zugegriffen werden kann und auf Arbeitsparameter bezogene elektronische Tunneldurchbruchwerte von der transparenten leitenden Schicht angenommen werden können.

6. Zu testendes Chip nach Anspruch 5, gekennzeichnet durch zumindest einen Ein-Ausgangskontakt (12), der für Testanschluß und Anschlußmittel (13) bestimmt ist, welche den Anschlußkontakt (12) mit der transparenten leitenden Oberschicht (3) verbinden (Abb. 3).

7. Zu testendes Chip nach Anspruch 5 oder 6, gekennzeichnet durch eine photonenundurchlässige Passivierungschicht (15), in welcher photonentransparente Fensteröffnungen (14) den Zugang zu den Teststellen (4) für Laserlicht ermöglichen (Abb. 3).

## Revendications

1. Procédé d'essai d'une puce de circuit intégré à essayer, caractérisé en ce que chaque circuit intégré à placer en essai comporte au moins un site d'essai conducteur (4), les sites d'essai sont couverts par une couche de passivation (2), la couche de passivation étant en une matière qui transmet les photons et qui est capable d'effet tunnel assisté par photons, une couche de recouvrement conductrice mince (3) est formée sur la couche de passivation (2), la couche de recouvrement étant transparente aux photons,
des moyens d'exécution d'essai de circuit intégré sont appliqués à la puce en essai pour provoquer dans la puce en essai une activité électronique appropriée à l'essai désiré, de façon à créer, à un site d'essai donné, un potentiel lié à l'opération,
un dispositif de laser pulsé (6) est mis en service pour accéder à un site d'essai choisi sur la puce en essai de manière à exciter une photo-émission d'électrons photo-excités à partir du site d'essai, à des valeurs liées au potentiel instantané au site d'essai accédé, de sorte que le site d'essai accédé fournit, par effet tunnel des électrons photo-excités à travers la couche de passivation (2) jusqu'à la couche de revêtement conductrice (3), des courants d'électrons de valeurs différentes en fonction des différences de potentiel de fonctionnement, et

des moyens de mesure de courant (9) sont connectés à la couche de recouvrement (3) pour mesurer les courants d'électrons d'effet tunnel qui sont eux-mêmes une fonction composite de l'excitation par lumière laser des sites d'essai et du potentiel instantané à ces sites d'essai, de sorte que le site d'essai atteint par le dispositif de laser pulsé fournit des indications différentes pour un fonctionnement correct et pour des fonctionnements défectueux, et le circuit intégré peut être vérifié sans essai comportant un contact destructif.

2. Procédé suivant la revendication 1, caractérisé en ce que des moyens de polarisation (10) sont connectés à la couche de recouvrement (3) du circuit intégré en essai, pour régler le seuil d'effet tunnel des électrons photo-excités, de sorte que le plot d'essai accédé par le dispositif de laser pulsé fournit des indications sensiblement différentes pour un fonctionnement correct et pour des fonctionnements défectueux.

3. Procédé suivant la revendication 1 ou 2, caractérisé en ce que la couche de recouvrement conductrice (3) est éliminée après achèvement de l'essai.

4. Procédé suivant la revendication 1, 2 ou 3, caractérisé en ce que la puce en essai (1) est placée dans un support (11) comportant des connexions électriques (8) complémentaires des connexions d'entrée/sortie de la puce en essai, et supportant la puce en essai pour permettre aux photons du laser d'accéder aux sites d'essai (4).

5. Puce de circuit intégré en essai comportant une pluralité de circuits intégrés opérationnels qui sont agencés sous une couche de passivation (2), caractérisée en ce que la couche de passivation (2) est en une matière qui transmet les photons et qui est capable d'un effet tunnel d'électrons pour les électrons photoexcités, en ce qu'une pluralité de plots d'essai conducteurs (4) sont prévus en association avec les circuits à essayer, à des endroits accessibles aux photons à travers la couche de passivation ; et une couche de recouvrement (3) transparente aux photons et électriquement conductrice est prévue sur la couche de passivation (2) pour constituer des moyens de connexion de sortie d'essai, de sorte que cette puce en essai peut être montée pour des opérations en mode defonctionnement d'essai, les sites d'essai peuvent être accédés par laser pendant les opérations, et des valeurs d'effet tunnel d'électrons liées à des paramètres opérationnels peuvent être mesurées à partir de la couche conductrice transparente.

6. Puce en essai suivant la revendication 5, caractérisée en ce qu'elle comporte au moins un contact d'entrée/sortie (12) prévu pour une connexion d'essai, et des moyens de connexion (13) reliant le contact de connexion d'essai (12) à la couche de recouvrement conductrice transparente (3) (figure 3).

7. Puce en essai suivant la revendication 5 ou 6, caractérisée en ce qu'elle comprend une couche de passivation (15) opaque aux photons, dans laquelle des fenêtres (14) transparentes aux photons permettent l'accès de la lumière laser aux sites d'essai (4) (figure 3).

# FIG.1

PULSED
LASER SYSTEM

FOCUSSING OPTICS

CHIP

CONTACT TO METAL
OVERLAYER

BOXCAR INTEGRATOR
SYSTEM TO MEASURE
CURRENT PULSE

CHIP
I/O LINES

EP 0 196 475 B1

# FIG.2

TUNNELING

B

LASER $k_v$

$E_F$

$E_F$

METAL TEST POINT
ON CHIP

PASSIVATION LAYER
(INSULATOR)

METAL OVERLAYER
(COLLECTOR)

EP 0 196 475 B1

FIG. 3

EP 0 196 475 B1